# EUROPÄISCHE PATENTSCHRIFT

(11) **EP 1 590 101 B1**
(45) Veröffentlichungstag und Bekanntmachung des Hinweises auf die Patenterteilung: **07.06.2006**
(21) Anmeldenummer: 04703102.6
(22) Anmeldetag: 17.01.2004
(51) Int. Cl.: B08B 3/12, G03F 7/20

(54) **VERFAHREN UND VORRICHTUNG ZUM ENTFERNEN VON VERNETZTEN POLYMEREN AUS METALLSTRUKTUREN**
METHODS AND DEVICE FOR REMOVING CROSS-LINKED POLYMERS FROM METAL STRUCTURES
PROCEDE ET DISPOSITIF POUR ELIMINER DES POLYMERES RETICULES DE STRUCTURES METALLIQUES

(30) Priorität: 07.02.2003 DE 10305270
(43) Veröffentlichungstag der Anmeldung: 02.11.2005
(73) Patentinhaber: Technotrans AG, 48336 Sassenberg (DE)
(72) Erfinder: HUMBACH, Oliver, 48351 Everswinkel (DE); SALMON, Alexander, 80937 München (DE); SCHRÖDER, Klaus-Dieter, 65185 Wiesbaden (DE)
(74) Vertreter: Steinmeister, Helmut
(86) Internationale Anmeldenummer: PCT/EP2004/000328
(87) Internationale Veröffentlichungsnummer: WO 2004/069437

(56) Entgegenhaltungen:
- US-A- 5 821 175
- US-A- 6 006 765
- US-A1- 2003 010 356

## Beschreibung

Die Erfindung betrifft ein Verfahren zum Entfernen eines Polymers, insbesondere einer vernetzten Epoxidharz-Struktur von einer durch galvanische Abscheidung an der Epoxidharz-Struktur gewonnenen Metallstruktur gemäß dem Oberbegriff der Ansprüche 1 und 7. Die Erfindung betrifft ferner eine Vorrichtung zur Durchführung der Verfahren.

Metallische Strukturen, insbesondere Mikrostrukturen, können hergestellt werden durch galvanische Abscheidung eines Metalls, beispielsweise Nickel, an einer aus Epoxidharz hergestellten Mikrostruktur. In der Mikrotechnik werden verschiedene Verfahren zur Herstellung von miniaturisierten Bauteilen genutzt, die in vielen Bereichen der modernen Technik angewendet werden können. Einige dieser Verfahren, beispielsweise das sogenannte LIGA-Verfahren, dessen Bezeichnung gebildet worden ist aus den Wörtern "Lithografie - Galvanik - Abformung", beruhen auf der Verwendung von lithografischen Techniken, mit denen Polymerstrukturen mit hoher Präzision bis hinab in den Submikrometerbereich hergestellt werden können. In Kombination mit galvanischen Verfahren können auf diese Weise Formeinsätze und Mikrokomponenten aus Metall hergestellt werden. Das setzt jedoch voraus, dass die Polymer-Strukturen mit vertretbaremAufwand vollständig von den gebildeten Metallkomponenten entfernt werden können.

Ein für die LIGA-Technik sehr gut geeigneter Photolack ist der auf einem Epoxidharz basierende SU-8. Dieser besitzt eine hohe photochemische Sensibilität und läßt sich auch in dicken Schichten auf Substrate auftragen. Für die Entfernung dieses Polymers werden auf dem Markt verschiedene sogenannte Resiststripper angeboten, die jedoch nur wirksam sind, wenn das Epoxidharz noch nicht vollständig vernetzt ist.

Bisher hat man metallische Mikrostrukturen mechanisch von dem Photolack befreit, indem man das Substrat zunächst in flüssigem Stickstoff abkühlt und dann schnell in einem warmen Wasserbad erwärmt.

Dabei nutzt man die unterschiedlichen thermischen Ausdehnungskoeffizienten des Polymers und des Metalls. Dieses Verfahren ist jedoch nur bei verhältnismäßig groben Strukturen wirksam. Alternativ kann man vernetztes Epoxidharz durch Verbrennen bzw. Veraschen zerstören.

Dazu werden jedoch Temperaturen von über 500°C benötigt. Galvanisch abgeschiedene Nickel-Strukturen unterliegen jedoch bereits bei Temperaturen um 300°C einer irreversiblen Gefügeänderung und damit einer erheblichen Verringerung der Festigkeit.

Neben dem Verbrennen oder Veraschen werden in der Literatur andere Verfahren zum Entfernen von Epoxidharzen, etwa durch Hochdruckextraktion oder Mikrowellenbestrahlung vorgeschlagen. Keines der bekannten Verfahren hat sich jedoch bisher als praxistauglich erwiesen.

Der Erfindung liegt die Aufgabe zugrunde, ein Verfahren und eine Vorrichtung anzugeben, die es gestatten, Polymerstrukturen von an diesen galvanisch abgeschiedenen Metallstrukturen in wirtschaftlicher Weise so zu entfernen, dass die Metallstrukturen in ihren Eigenschaften nicht beeinträchtigt werden.

Diese Aufgabe wird bei einem Verfahren der obigen Art gemäß einer ersten Ausführungsform dadurch gelöst, dass die Metallstruktur mit anhaftender Epoxidharz-Struktur in ein Bad einer stark oxidierenden Säure eingebracht und zugleich einer Megaschall-Schwingung ausgesetzt wird.

Unter Megaschall soll hier ein im nicht hörbaren Bereich befindlicher Schall mit einer Frequenz im Megahertz-Bereich verstanden werden.

Unter stark oxidierenden Säuren sollen hier Säuren wie rauchende Schwefelsäure (Oleum) oder rauchende Salpetersäure verstanden werden. Es hat sich überraschenderweise gezeigt, dass bei der kombinierten Einwirkung von Megaschall und einer starken Säure die Epoxidharz-Bestandteile bis in die feinsten Strukturbereiche hinein von der Metallstruktur gelöst werden. Sie können dann zusammen mit der Säure ausgetragen werden.

Bei der Durchführung des Verfahrens wird das Metall-Substrat vorzugsweise in ein Säurebad eingebracht, mit dem eine Megaschall-Quelle in Verbindung steht. Diese wird aktiviert und nach vorgegebener Behandlungszeit wieder abgeschaltet, und anschließend wird das Säurebad abgelassen.

In vorteilhafter Weise kann die Megaschall-Energie auf die Metallstruktur über ein Wasserbad übertragen werden, in dem sich eine Behandlungskammer für die Metallstruktur mit dem Säurebad befindet.

Entsprechend einer alternativen Ausführungsform wird die Metallstruktur mit anhaftender Polymerstruktur in ein Bad einer stark oxidierenden Säure eingebracht, und die Metallstruktur wird in dem Säurebad einer Elektrolysebehandlung unterworfen, bei der die Metallstruktur als Kathode geschaltet und zusätzlich im Säurebad eine Anode aus Inertmaterial vorgesehen wird, vorzugsweise eine Mischoxidelektrode wie beispielsweise Iridiumoxid auf Titan oder Platin bzw. platiniertes Titan.

Auch bei dieser Ausführungsform des erfindungsgemäßen Verfahrens kommen die oben genannten Säuren in Betracht.

Wie bei dem ersten Verfahren, kann die Säure vor Durchführung einer Behandlung aus einem Behälter in eine Behandlungskammer überführt und nach Durchführung des Verfahrens zurück in den Behälter geleitet werden.

Die beiden zuvor definierten Verfahren, nämlich die Behandlung der in einem Säurebad befindlichen Metallstruktur mit Megaschall sowie durch Elektrolyse lassen sich miteinander kombinieren, indem die Metallstruktur in einem Säurebad als Kathode geschaltet, ferner im Säurebad eine Anode vorgesehen wird und zugleich eine Einwirkung durch Megaschall stattfindet.

Eine erfindungsgemäße Vorrichtung läßt sich den Merkmalen des Anspruchs 11 entnehmen. Im weiteren Verlauf soll eine Vorrichtung beschrieben werden, die für die Durchführung der beiden Varianten des erfindungsgemäßen Verfahrens sowohl jeweils für sich als auch in Kombination geeignet ist.

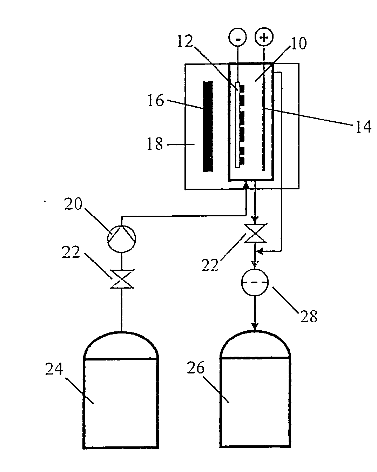

Im folgenden soll eine bevorzugte Ausführungsform der Erfindung anhand der beigefügten Zeichnung näher erläutert werden.

Die einzige Figur zeigt eine Vorrichtung, die zur Durchführung beider Ausführungsformen des Verfahrens geeignet ist.

Die einzige Figur zeigt in einer schematischen, teilweise schnittartig dargestellten Ansicht eine verschließbare Behandlungskammer 10 vorzugsweise aus Quarzglas, in der eine von einem Polymer zu befreiende Metallstruktur 12 fest angeordnet, z. B. eingespannt ist.

In der Behandlungskammer 10 befindet sich ein Säurebad. Wie durch die in der Zeichnung dargestellten Zeichen + und - verdeutlicht wird, wird die Metallstruktur 12 als Kathode geschaltet, und eine Anode 14 befindet sich innerhalb des Säurebades in Abstand gegenüber der Kathode.

Während dies die wesentlichen Elemente zur Durchführung der zweiten Ausführungsform des erfindungsgemäßen Verfahrens sind, ist die Behandlungskammer 10 von einem Becken mit separatem Wasserbad 18 umgeben, in dem ein Megaschall-Schwinger 16 angeordnet ist. Auf diese Weise wird die Megaschall-Energie direkt über das Medium Wasser auf die Behandlungskammer und durch diese auf die Metallstruktur 12 übertragen.

Über ein Leitungssystem mit Pumpe 20 und steuerbarem Ventil 22, jeweils bestehend aus säurefesten Materialien, wie Edelstahl, ist die Behandlungskammer mit dem Vorratsbehälter 24 verbunden. In dem Vorratsbehälter 24 befindet sich eine geeignete Säure, z. B. rauchende Salpetersäure. Die Vorratsbehälter können aus Glas bestehen. Das Säurebad in der Behandlungskammer 10 wird nach Beendigung des Prozesses über ein zweites Leitungssystem mit Ventil 22 und Filter 28 in einen Entsorgungsbehälter 26 zurückgeleitet.

Alternativ kann statt der zwei Behälter 24 und 26 nur ein Behälter eingesetzt werden, in den sowohl Zu- als auch Rücklauf münden. Auf diese Weise kann die Säure mehrfach wiederverwertet werden, wobei die Qualität der Säure über ein integriertes Photometer überwacht wird.

Beide Varianten des erfindungsgemäßen Verfahrens können programmgesteuert ablaufen. Auf diese Weise können die einzelnen Schritte, wie Zu- und Abfuhr der Säure, Anlegen und Abschalten des Elektrolysestroms, Ein- und Ausschalten des Megaschall-Schwingers, im gewünschten Takt ablaufen.

### Beispiel 1:

Entfernung des Epoxidharzes durch Exposition in Oleum und Megaschall-Einwirkung.

Die verwendete Probe besteht aus einer Epoxidharzstruktur aus SU-8. die galvanisch mit einer Nickel-Eisen Legierung aufgefüllt und zu einem Formeinsatz überwachsen ist. Die SU-8-Schicht ist, 300 µm hoch und teilt sich in vielfältige Mikrostrukturen mit unterschiedlichen Abmessungen.

Die kleinsten Strukturabmessungen sind < 20 µm breit, so dass Aspektverhältnisse (Verhältnis Strukturhöhe zu -breite) oberhalb von 15 erreicht werden.

Die Probe wird in ein Prozessbecken aus Quarzglas eingehängt in das Oleum (20% SO₃) eingeleitet wird. Über einen Tauchschwingkopf, der in einem umgebenden Wasserbad angeordnet ist, wird Megaschallenergie (Frequenz 1 MHz, Leistung 500 W) in das Prozessbecken eingebracht.

Das SU-8 wird innerhalb einer Zeit von 60 min vollständig aus den NiFe-Strukturen entfernt.

Die Metalloberfläche wird bei diesem Prozess nicht angegriffen. Mit dem Auge ist ein Oberflächenglanz zu sehen; unter dem Lichtmikroskop sind ebenfalls keine Beschädigungen des Metalls zu erkennen.

### Beispiel 2:

Entfernung des Epoxidharzes durch Elektrolyse in rauchender Salpetersäure

Die verwendete Probe besteht aus einer Epoxidharz-Struktur aus SU-8 mit einer Kantenlänge von 500 *µ*m, die galvanisch mit Nickel aufgefüllt ist. SU-8 und Nikkel befinden sich auf einer Silizium-Trägerscheibe, die mit einer Galvanikstartschicht aus Gold versehen ist.

Zur Entfernung des Polymers wird die Probe als Kathode geschaltet und mit angelegtem Potential in rauchende Salpetersäure eingetaucht. Als Gegenelektrode (Anode) wird platiniertes Titan verwendet. Die Elektrolysedauer bei einer Startstromdichte von 10 A/dm² beträgt 10 Minuten.

Nach einer Versuchsdauer von 10 Minuten ist die Nickelstruktur vollständig vom SU-8 befreit. Dies wird mithilfe von REM-Analysen nachgewiesen. Lediglich oberflächennahe Bereiche des Nickels besitzen einen merklichen Sauerstoffanteil aufgrund der Behandlung. Eine Beeinträchtigung der Qualität der Nickelstruktur hat nicht stattgefunden.

## Patentansprüche

1. Verfahren zum Entfernen eines Polymers, insbesondere einer vernetzten Epoxidharz-Struktur von einer durch galvanische Abscheidung an der Epoxidharz-Struktur gewonnenen Metallstruktur, **dadurch gekennzeichnet, dass** die Metallstruktur mit anhaftender Epoxidharz-Struktur in ein Bad einer stark oxidierenden Säure eingebracht und zugleich einer Megaschall-Schwingung ausgesetzt wird.

2. Verfahren nach Anspruch 1, **dadurch gekennzeichnet, dass** als Säure eine konzentrierte Schwefelsäure, rauchende Schwefelsäure (Oleum), rauchende Salpetersäure oder dergleichen verwendet wird.

3. Verfahren nach Anspruch 1 oder 2, **dadurch gekennzeichnet, dass** das Metallsubstrat in ein Prozessbecken eingebracht, ein Säurebad zugeleitet und dass danach die Megaschall-Quelle aktiviert wird, dass nach vorgegebener Behandlungsdauer die Megaschall-Quelle abgeschaltet wird und dass die Säure aus dem Säurebad anschließend in einen Behälter abgelassen wird.

4. Verfahren nach Anspruch 3, **dadurch gekennzeichnet, dass** die Megaschall-Energie auf die Metallstruktur über ein Wasserbad übertragen wird, in dem sich die Behandlungskammer befindet.

5. Verfahren nach Anspruch 4, **dadurch gekennzeichnet, dass** die Metallstruktur in dem Säurebad als Kathode geschaltet wird, dass im Säurebad eine Anode aus Inertmaterial angeordnet wird und dass zusätzlich zu dieser Elektrolysebehandlung eine Megaschall-Einwirkung erfolgt.

6. Verfahren zum Entfernen eines Polymers, insbesondere einer vernetzten Epoxidharz-Struktur von einer durch galvanische Abscheidung an der Epoxidharz-Struktur gewonnenen Metallstruktur, **dadurch gekennzeichnet, dass** die Metallstruktur mit anhaftender Epoxidharz-Struktur in ein Bad einer stark oxidierenden Säure eingebracht wird und dass die Metallstruktur einer Elektrolysebehandlung unterworfen wird, bei der die Metallstruktur als Kathode geschaltet und zusätzlich in dem Säurebad eine Anode aus Inertmaterial vorgesehen wird.

7. Verfahren nach Anspruch 6, **dadurch gekennzeichnet, dass** als Säure eine konzentrierte Schwefelsäure, rauchende Schwefelsäure (Oleum), rauchende Salpetersäure oder dergleichen verwendet wird.

8. Verfahren nach Anspruch 6 oder 7, **dadurch gekennzeichnet, dass** als Anode eine Mischoxidelektrode, insbesondere Iridiumoxid, verwendet wird.

9. Verfahren nach Anspruch 7 oder 8, **dadurch gekennzeichnet, dass** die Säure vor der Durchführung einer Behandlung in eine Behandlungskammer eingeleitet und nach der Durchführung der Behandlung über ein Filtersystem in einen Behälter zurückgeleitet wird.

10. Verfahren nach einem der Ansprüche 6 oder 7, **dadurch gekennzeichnet, dass** zusätzlich zu der Elektrolysebehandlung der Metallstruktur eine Einwirkung von Megaschall vorgesehen wird.

11. Vorrichtung zum Entfernen eines Polymers, insbesondere einer vernetzten Epoxidharz-Struktur von einer durch galvanische Abscheidung an der Epoxidharz-Struktur gewonnenen Metallstruktur, insbesondere zur Durchführung des Verfahrens gemäß einem der Ansprüche 1 bis 10, **gekennzeichnet durch** eine Behandlungskammer (10) zur Aufnahme eines Säurebades, in der eine Halterung für die Aufnahme einer Metallstruktur vorgesehen ist, dass die Metallstruktur (12) als Kathode schaltbar und dass im übrigen innerhalb der Behandlungskammer (10) eine Anode (14) aus Inertmaterial vorgesehen ist, und dass mit der Behandlungskammer ein Megaschall-Schwinger (16) über ein Wasserbad verbunden ist.

## Claims

1. A method for removing a polymer, especially a cross-linked epoxy resin structure from a metal structure obtained by galvanic deposition on the epoxy resin structure, **characterised in that** the metal structure with the adherent epoxy resin structure is introduced into a bath of a strongly oxidising acid and simultaneously subjected to a megasonic oscillation.

2. A method according to claim 1, **characterised in that** a concentrated sulphuric acid, fuming sulphuric acid (oleum), fuming nitric acid or the like is used as the acid.

3. A method according to claim 1 or 2, **characterised in that** the metal substrate is introduced into a process vessel, an acid bath is admitted and **in that** subsequently the megasonic energy source is activated, **in that** after a predetermined treatment length the megasonic energy source is switched off and **in that** the acid is subsequently drained from the acid bath into a container.

4. A method according to claim 3, **characterised in that** the megasonic energy is transmitted to the metal structure via a water bath in which the treatment chamber is located.

5. A method according to claim 4, **characterised in that** the metal structure in the acid bath is connected in the form of a cathode and an anode of inert material is arranged in the acid bath and **in that**, in addition to this electrolysis treatment, exposure to the action of megasonic energy is effected.

6. A method for removing a polymer, especially a cross-linked epoxy resin structure from a metal structure obtained by galvanic deposition on the epoxy resin structure, **characterised in that** the metal structure with the adherent epoxy resin structure is introduced into a bath of a strongly oxidising acid and **in that** the metal structure is subjected to an electrolysis treatment, in which the metal structure is connected in the form of a cathode and an anode of inert material is additionally provided in the acid bath.

7. A method according to claim 6, **characterised in that** a concentrated sulphuric acid, fuming sulphuric acid (oleum), fuming nitric acid or the like is used as the acid.

8. A method according to claim 4, **characterised in that** a mixed oxide electrode, especially iridium oxide, is used as the anode.

9. A method according to claim 7 or 8, **characterised in that** the acid is introduced before carrying out a treatment in a treatment chamber and after carrying out the treatment is returned via a filter system to a container.

10. A method according to one of claims 6 and 7, **characterised in that** in addition to the electrolysis treatment of the metal structure, exposure to the action of megasonic energy is provided.

11. A device for removing a polymer, especially a cross-linked epoxy resin structure from a metal structure obtained by galvanic deposition on the epoxy resin structure, especially for carrying out the method according to any one of claims 1 to 10, **characterised by** a treatment chamber (10) for receiving an acid bath, in which a holder for receiving a metal structure is provided, in that the metal structure (12) is connectible in the form of a cathode and in that otherwise within the treatment chamber (10) an anode (14) of inert material is provided, and in that a megasonic oscillator (16) is connected to the treatment chamber via a water bath.

## Revendications

1. Procédé pour éliminer un polymère, en particulier une structure réticulée de résine époxy, d'une structure métallique obtenue par séparation galvanique sur la structure de résine époxy, **caractérisé en ce que** la structure métallique est introduite avec la structure de résine époxy adhérente dans un bain d'un acide fortement oxydant et est soumise en même temps à une vibration par mégasons.

2. Procédé selon la revendication 1, **caractérisé en ce qu'**on utilise comme acide un acide sulfurique concentré, de l'acide sulfurique fumant (oléum), de l'acide nitrique fumant ou analogues.

3. Procédé selon la revendication 1 ou 2, **caractérisé en ce que** le substrat de métal est introduit dans une cuve de processus, un bain d'acide y est alimenté et **en ce qu'**ensuite la source de mégasons est activée, **en ce qu'**après une durée de traitement prédéfinie la source de mégasons est mise hors service et **en ce que** l'acide provenant du bain acide est ensuite évacué dans un récipient.

4. Procédé selon la revendication 3, **caractérisé en ce que** l'énergie des mégasons est transmise à la structure métallique par un bain d'eau dans lequel se trouve la chambre de traitement.

5. Procédé selon la revendication 4, **caractérisé en ce que** la structure métallique est couplée dans le bain d'acide en tant que cathode, **en ce que** dans le bain d'acide est disposée une anode en un matériau inerte et **en ce qu'**en supplément à ce traitement électrolytique, on fait agir des mégasons.

6. Procédé pour éliminer un polymère, en particulier une structure réticulée de résine époxy, d'une structure métallique obtenue par séparation galvanique sur la structure de résine époxy, **caractérisé en ce que** la structure métallique est introduite avec la structure de résine époxy adhérente dans un bain d'un acide fortement oxydant, et **en ce que** la structure métallique est soumise à un traitement électrolytique pour lequel la structure métallique est couplée en tant que cathode et il est prévu en supplément dans le bain d'acide une anode en un matériau inerte.

7. Procédé selon la revendication 6, **caractérisé en ce qu'**on utilise comme acide un acide sulfurique concentré, de l'acide sulfurique fumant (oléum), de l'acide nitrique fumant ou analogues.

8. Procédé selon la revendication 6 ou 7, **caractérisé en ce qu'**on utilise comme anode une électrode en oxyde mixte, en particulier en oxyde d'iridium.

9. Procédé selon la revendication 7 ou 8, **caractérisé en ce qu'**avant la mise en oeuvre d'un traitement, l'acide est introduit dans une chambre de traitement et après la mise en oeuvre du traitement, il est recyclé dans un récipient, par l'intermédiaire d'un système filtrant.

10. Procédé selon l'une des revendications 6 ou 7, **caractérisé en ce qu'**en plus du traitement électrolytique de la structure métallique, on fait agir des mégasons.

11. Dispositif pour éliminer un polymère, en particulier pour la mise en oeuvre du procédé selon l'une des revendications 1 à 10, en particulier une structure réticulée de résine époxy, d'une structure métallique obtenue par séparation galvanique sur la structure de résine époxy, **caractérisé par** une chambre de traitement (10) pour recevoir un bain d'acide dans laquelle est prévue une fixation pour la réception d'une structure métallique, en ce que la structure métallique (12) peut être couplée en tant que cathode et en ce que par ailleurs, à l'intérieur de la chambre de traitement (10) est prévue une anode (14) en un matériau inerte, et en ce qu'un générateur de mégasons (16) est relié à la chambre de traitement par un bain d'eau.
